(19) Europäisches Patentamt
European Patent Office
Office européen des brevets

(11) **EP 3 326 437 B1**

(12) **EUROPÄISCHE PATENTSCHRIFT**

(45) Veröffentlichungstag und Bekanntmachung des Hinweises auf die Patenterteilung:
**10.04.2019 Patentblatt 2019/15**

(21) Anmeldenummer: **16778735.7**

(22) Anmeldetag: **30.09.2016**

(51) Int Cl.:
*H05K 3/10* (2006.01)   *H05K 3/14* (2006.01)
*C23C 24/10* (2006.01)   *H05K 3/02* (2006.01)

(86) Internationale Anmeldenummer:
**PCT/EP2016/073386**

(87) Internationale Veröffentlichungsnummer:
**WO 2017/063899 (20.04.2017 Gazette 2017/16)**

(54) **VERFAHREN ZUM HERSTELLEN VON STRUKTURIERTEN BESCHICHTUNGEN AUF EINEM FORMTEIL UND VORRICHTUNG ZUR DURCHFÜHRUNG DES VERFAHRENS**

METHOD FOR CREATING PATTERNED COATINGS ON A MOLDED ARTICLE, AND DEVICE FOR CARRYING OUT SAID METHOD

PROCÉDÉ DE PRODUCTION DE REVÊTEMENTS STRUCTURÉS SUR UNE PIÈCE MOULÉE ET DISPOSITIF PERMETTANT LA MISE EN OEUVRE DUDIT PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.10.2015 DE 102015117558**

(43) Veröffentlichungstag der Anmeldung:
**30.05.2018 Patentblatt 2018/22**

(73) Patentinhaber:
• **Plasma Innovations GmbH**
  **4800 Attnang-Puchheim (AT)**
• **LPKF Laser & Electronics AG**
  **30827 Garbsen (DE)**

(72) Erfinder:
• **BISGES, Michael**
  **93049 Regensburg (DE)**

• **OSTHOLT, Roman**
  **30855 Langenhagen (DE)**
• **RÖSENER, Bernd**
  **32457 Porta Westfalica (DE)**
• **DUNKER, Daniel**
  **30419 Hannover (DE)**

(74) Vertreter: **Kohlmann, Kai**
  **Donatusstraße 1**
  **52078 Aachen (DE)**

(56) Entgegenhaltungen:
WO-A1-2016/173963   DE-A1- 19 828 987
DE-A1-102006 061 435   GB-A- 2 089 581
GB-A- 2 451 656   US-A- 2 893 150
US-A- 3 042 591   US-A1- 2004 055 153

## Beschreibung

Die Erfindung betrifft ein Verfahren zum Herstellen von strukturierten Beschichtungen auf einem Formteil und eine Vorrichtung zur Durchführung des Verfahrens. Bei dem Formteil handelt es sich insbesondere um einen planaren oder räumlichen Schaltungsträger, aus einem isolierendem Material, der mit einer strukturierten metallischen Beschichtung, insbesondere einer Leiterbahnstruktur versehen wird. Außerdem betrifft die Erfindung eine Vorrichtung zur Durchführung des Verfahrens.

Bei subtraktiven Verfahren zur Herstellung von planaren Schaltungsträgern (Leiterplatten) entsteht die Leiterbahnstruktur durch das teilweise Entfernen einer Metallisierung, die zuvor auf dem Schaltungsträger aufgebracht wird. Bei additiven Verfahren wird die Leiterbahnstruktur durch das gezielte Abscheiden einer Metallisierung auf dem Schaltungsträger aufgebracht.

Planare Schaltungsträgern (Leiterplatten) bestehen zumeist aus einem elektrisch isolierendem Material. Als isolierendes Material ist faserverstärkter Kunststoff (FR4) üblich. Die Leiterbahnstrukturen werden auf Leiterplatten photolithografisch aus einer dünnen Metallisierungsschicht, insbesondere aus Kupfer wie folgt hergestellt:
Eine dünne Schicht lichtempfindlichen Fotolacks wird auf die Oberfläche der noch vollständig metallisierten Leiterplatte aufgebracht. Nach der Belichtung des Fotolacks durch eine Maske mit der gewünschten Struktur sind je nach verwendetem Fotolack entweder die belichteten oder die unbelichteten Anteile des Fotolacks in einer Entwicklerlösung löslich und werden entfernt. Bringt man die so behandelte Leiterplatte in eine geeignete Ätzlösung (z.B. in Wasser gelöstes Eisen(III)-Chlorid oder Natriumpersulfat), so wird nur der fotolackfreie Bereich der metallisierten Oberfläche von der Ätzlösung entfernt; die vom Fotolack bedeckten Bereiche bleiben erhalten, weil der Fotolack beständig gegen die Ätzlösung ist.

Diese subtraktiven, nasschemischen Verfahren unterliegen aus Umweltschutzgesichtspunkten Einschränkungen. Außerdem lassen sich die subtraktiven, nasschemischen Verfahren praktisch nur mit Leiterplatten aus FR4 Material durchführen. Kunststoffe kommen als Material nicht in Betracht, da die in den Kunststoffen enthaltenen Additive durch die nasschemischen Verfahrensschritte instabil werden und die in den Bädern gelösten Additive die Eigenschaften der Metallisierung verändern. Hinzu kommt, dass eine Herstellung von nicht planaren, sondern räumlichen Schaltungsträgern mit subtraktiven, nasschemischen Verfahren wirtschaftlich nicht möglich ist.

Bei spritzgegossenen, räumlichen Schaltungsträgern (Molded Interconnect Device, MID) können indes auf der Oberfläche von Formteilen aus Kunststoff Leiterbahnstrukturen erzeugt werden. Der Schaltungsträger erhält durch den Spritzgussprozess seine räumliche, dreidimensionale Form und die Leiterbahnstrukturen werden zumeist additiv elektrochemisch oder chemisch auf der Oberfläche aufgebracht. Für das Formteil kommen im Wesentlichen Hochtemperatur- und Konstruktionsthermoplaste zum Einsatz. Die lange Prozessdauer zur Herstellung der spritzgegossenen, räumlichen Schaltungsträger ist jedoch für eine massenhafte, wirtschaftliche Herstellung von räumlichen Schaltungsträgern weniger geeignet.

Aus der DE 11 2012 004 940 T5 ist ein Verfahren zum Herstellen einer Leiterbahnstruktur auf einem Substrat mit den folgenden Schritten bekannt:

- Ausbildung einer ersten Metallschicht auf einem nichtleitenden Substrat;

- Gezieltes Entfernen eines Teils der ersten Metallschicht mittels eine Lasers, um das nichtleitende Substrat freizulegen, um so die erste Metallschicht als einen beschichteten Bereich und einen nicht beschichteten Bereich auszubilden, wobei der beschichtete Bereich in zwei Leiterbahnen bildende Abschnitte und mindestens einen Brückenabschnitt aufgeteilt ist;

- Ausbildung einer zweiten Metallschicht auf dem beschichteten Bereich durch galvanisches Beschichten nur des beschichteten Bereichs unter Verwendung eines der die Leiterbahnen bildenden Abschnitte und des Brückenabschnitts als Elektrode, und

- Entfernen des Brückenabschnitts und der auf dem Brückenabschnitt gebildeten zweiten Metallschicht. Das Entfernen kann durch gezielte Laserabtragung erfolgen. Damit ist das Verfahren zur Herstellung der strukturierten Leiterbahn abgeschlossen. Der Entfernungsschritt kann jedoch auch chemisch durchgeführt werden, indem das strukturierte Substrat in ein chemisches Bad eingetaucht wird. Da die Leiterbahnen bildenden Abschnitte breiter sind als die dazwischen angeordneten Brückenabschnitte können die Brückenabschnitte und die darauf gebildete zweite Metallschicht durch einstellen der Eintauchzeit wirksam entfernt werden, ohne sich negativ auf die Leiterbahnen bildenden Abschnitte auszuwirken.

Aus der GB 2 089 581 A ist ein Verfahren zur Herstellung einer leitfähigen Beschichtung auf einem Substrat bekannt, wobei zunächst eine ungehärtete organische Harzzusammensetzung mit klebriger Oberfläche auf dem Substrat als Beschichtung aufgebracht wird. Die Beschichtung wird sodann einer UV-Bestrahlung durch eine Schaltbildmaske, deren Schaltbild hinsichtlich der gewünschten Schaltung positiv ist, ausgesetzt, um in den bestrahlten Bereichen eine gehärtete an dem Substrat haftende Beschichtung auszubilden. Sodann werden die nicht UV-bestrahlten, ungehärteten Bereiche mit einem elektrisch leitfähigen Material beschichtet. Anschließend werden die ungehärteten Bereiche einer Temperatur zum Härten bzw. UV-Strahlung ausgesetzt, um das elektrisch leitfähige Material auf ihrer Oberfläche zu fixieren. Das lose elektrisch leitfähige Material wird beispielsweise durch Abbürsten, Abklopfen oder ein Luftspray entfernt.

Die US 289 315 0 A offenbart ein Verfahren zum Herstellen von strukturierten Beschichtungen auf einer Leiterplatte, die gegenüber der Plattenebene erhabene Bereiche zur Ausbildung der Leiterbahn- Strukturen aufweist. Auf die erhabenen Bereiche wird mittels Walzen Klebstoff aufgebracht. Anschließend wird die derart vorbereitete Leiterplatte mittels eines Förderers in Richtung einer Düse verfahren. Mittels der Düse werden Kupferpartikel vollflächig auf die Oberfläche der Leiterplatte aufgebracht. Aufgrund des selektiven Klebstoffauftrags ist die Haftfestigkeit der Kupferbeschichtung auf den erhabenen Bereichen höher als in den dazwischen befindlichen Bereichen. Nach Trocknung des Klebstoffs wird die Leiterplatte mittels des Förderers in Richtung einer Vakuumstation verfahren, die die nicht anhaftenden Kupferpartikel in den nicht mit Klebstoff versehenen Bereichen entfernt.

Ausgehend von diesem Stand der Technik liegt der Erfindung die Aufgabe zugrunde, ein subtraktives Verfahren zum Herstellen von strukturierten Beschichtungen auf einem Formteil vorzuschlagen, dass für eine massenhafte, preiswerte Herstellung von beschichteten, insbesondere räumlichen Formteilen geeignet ist, wobei sich die Abtragleistung des Abtragsverfahrens genau justieren lässt. Insbesondere soll ein subtraktives Verfahren für eine massenhafte, preiswerte Herstellung von räumlichen Schaltungsträgern aus Kunststoff mit metallischen Leiterbahnstrukturen vorgeschlagen werden. Schließlich soll eine Vorrichtung zur Durchführung des Verfahrens angegeben werden.

Diese Aufgabe wird durch ein Verfahren mit den Merkmalen des Anspruchs 1 sowie eine Vorrichtung mit den Merkmalen des Anspruchs 11 gelöst.

Die unterschiedliche Haftfestigkeit der Beschichtung in dem mindestens einen ersten Bereich und dem mindestens einen zweiten Bereich der Oberfläche des Formteils wird erfindungsgemäß für das teilweise Entfernen der Beschichtung mittels des Abtragverfahrens genutzt. Das Abtragverfahren wird während des Abtragprozesses mit einer konstanten Abtragleistung betrieben, die derart bestimmt wird, dass die Beschichtung in jedem zweiten Bereich aufgrund der dort geringeren Haftfestigkeit vollständig entfernt wird, während die Beschichtung in jedem ersten Bereich vollflächig erhalten bleibt. Abhängig von den Parametern des $CO_2$-Schneestrahlens kann sich jedoch die Schichtdicke der Beschichtung auch in jedem ersten Bereich durch das Abtragverfahren reduzieren, ohne jedoch den darunter liegenden ersten Bereich der Oberfläche des Formteils freizugeben.

Das Formteil besteht vorzugsweise aus elektrisch isolierendem Material, insbesondere Kunststoffen, wie Polycarbonat oder Polycarbonat-ABS.

Das Formteil kann eine ebene, jedoch auch eine beliebige geometrische dreidimensionale Form aufweisen; es kann aus flachen oder gekrümmten Flächenstücken zusammengesetzt sein.

Zur Erzeugung einer höheren Haftfestigkeit der Beschichtung in dem ersten Bereich gegenüber dem zweiten Bereich auf der Oberfläche des Formteils können sich die Oberflächen des ersten und zweiten Bereiches in einer oder mehrerer der nachfolgenden Oberflächeneigenschaften unterscheiden:

- Rauheit und/oder
- Härte und/oder
- Oberflächenspannung und/oder
- Materialstruktur und/oder
- Material.

Die unterschiedlichen Oberflächeneigenschaften des Formteils lassen sich einerseits durch gezielte Oberflächenbehandlung in dem ersten und/oder zweiten Bereich oder durch bereichsweise abweichende Materialien erzielen. Als Oberflächenbehandlung kommt beispielsweise eine Plasmaaktivierung oder eine Laserbehandlung in Betracht. Unterschiedliche Materialien an der Oberfläche des Formteils lassen sich beispielsweise durch partielle Lackierungen, Bedruckungen, Mehrkomponentenspritzguss oder das Laminieren von unterschiedlichen Materialien erzeugen.

Um durch das Abtragverfahren mit einer bestimmten, konstanten Abtragleistung in dem zweiten Bereich zuverlässig die Beschichtung vollständig zu entfernen, ist die Haftfestigkeit der Beschichtung in dem ersten Bereich um mindestens 5% vorzugsweise jedoch um mindestens 50% höher als in dem zweiten Bereich. Durch Verändern der Materialstruktur eines Formteils aus Kunststoff können Haftfestigkeiten in dem strukturierten ersten Bereich von 200-500 N/cm$^2$ und den zweiten Bereichen von weniger als 10 N/cm$^2$ erreicht werden.

Zur Bestimmung der Haftfestigkeit der Beschichtung in dem ersten und zweiten Bereich wird vorzugsweise der Stirnabzugstest nach DIN EN ISO 4624: 2003 verwendet. Der Stirnabzugstest dient zum Bestimmen der Haftfestigkeit durch Abreißen einer einschichtigen Beschichtung oder eines Mehrschichtsystems durch Messung der minimalen Zugspannung, die erforderlich ist, um die Beschichtung senkrecht von der Oberfläche des Formteils abzutrennen oder abzureißen. Das Prüfergebnis im Rahmen des Stirnabzugtests wird nicht nur von den mechanischen Eigenschaften des zu prüfenden Systems beeinflusst, sondern auch durch die Art und Vorbereitung der Oberfläche des Formteils, durch das Verfahren zum Aufbringen der Beschichtung sowie andere Umgebungsfaktoren. Insoweit ist der Stirnabzugstest für die Messung der Haftfestigkeit in dem vorliegenden Verfahren besonders geeignet.

Als Beschichtungsmaterial werden bevorzugt elektrisch leitfähige Materialien, insbesondere Metallpulver verwendet, insbesondere aus Kupfer oder Mischungen aus Kupfer und Zinn. Die Beschichtung wird mit einer Schichtdicke im Bereich von 1 μm bis 500 pm, vorzugsweise im Bereich von 5-50 μm auf die Oberfläche des Formteils aufgebracht. Die aufgebrachte Beschichtung weist vorzugsweise eine Porosität von mindestens 3% auf. Die Porosität ist das Verhältnis des Hohlraumvolumens der aufgebrachten Beschichtung zu dem Gesamtvolumen der Beschichtung. Das Gesamtvolumen setzt sich aus dem Hohlraumvolumen und dem Reinvolumen des Feststoffes zusammen:

$$\Phi = \frac{V_H}{V} = \frac{V_H}{V_H + V_F}$$

mit

Φ Porosität
$V_H$ Hohlraumvolumen
$V_F$ Reinvolumen des Feststoffes
V Gesamtvolumen

Das Aufbringen der Beschichtung auf die Oberfläche des Formteils erfolgt vorzugsweise mit einem der nachfolgenden Beschichtungsverfahren:

1. Laserbeschichtungsverfahren umfassend folgende Schritte:

- Bereitstellen eines Gasgemischstroms umfassend ein Trägergas und ein Beschichtungsmaterial,
- Zuführen des Gasgemischstroms zu der Oberfläche, wobei der Gasgemischstrom auf die Oberfläche auftrifft und das dort aufgebrachte Beschichtungsmaterial einen Auftreffbereich auf der Oberfläche ausbildet,
- Einkoppeln mindestens eines Laserstrahls in den Gasgemischstrom, wobei jeder Laserstrahl derart auf den Gasgemischstrom ausgerichtet wird, dass der Laserstrahl den Auftreffbereich auf der Oberfläche nicht trifft.
Dieses Verfahren zeichnet sich durch eine Aufschmelzung des Beschichtungsmaterials noch in dem Gasgemischstrom aus, bei zugleich geringer thermischer Belastung der Oberfläche des Formteils.

2. Ein Plasmabeschichtungsverfahren ermöglicht eine automatisierte Abscheidung insbesondere metallischer Beschichtungsmaterialien aus einem kaltaktiven Atmosphärendruck-Plasma direkt auf die Oberfläche des Formteils. Die Erzeugung des Gasplasmas erfolgt durch eine Gasentladung. Diesen kalten, nicht thermischen Plasmen mit Temperaturen zwischen 120 und 250 Grad Celsius wird unter Umgebungsbedingungen das Beschichtungsmaterial kontinuierlich zugeführt. Der Korndurchmesser des Beschichtungsmaterials beträgt vorzugsweise 100 nm bis 20 μm. Mit dem Plasmabeschichtungsverfahren lassen sich homogene Beschichtungen mit reproduzierbaren Schichtdicken bei Prozessgeschwindigkeiten bis zu 150 m/min erzeugen. Das Plasmabeschichtungsverfahren ist daher für die preiswerte und massenhafte Herstellung von strukturierten Beschichtungen besonders geeignet. Die metallischen Beschichtungen, insbesondere die Leiterbahnstrukturen können mit einer Dicke zwischen 1 und 1.000 μm aufgebracht werden.

3. Ein Aerosoljet-Verfahren ist zur Abscheidung von Beschichtungen mit feinsten Strukturen im Bereich deutlich unter 50 μm geeignet. Das Beschichtungsmaterial liegt beim Aerosoljet-Verfahren als flüssiges Material in einem Zerstäuber vor, wo pneumatisch oder mittels Ultraschall das aufzubringende Aerosol erzeugt wird. Dies wird zu einem Auftragskopf mit einer Düse transportiert. Über die Düse wird das Aerosol auf die Oberfläche des Formteils aufgebracht.

4. Bei einem Tauchbeschichtungsverfahren wird das Formteil, zumindest jedoch dessen zu beschichtende Oberfläche in eine Beschichtungslösung eingetaucht und anschließend wieder herausgezogen. Beim Herausziehen bleibt ein dünner Flüssigkeitsfilm auf der Oberfläche zurück. Alternativ wird die Oberfläche des Formteils nicht durch Eintauchen in die Beschichtungslösung beschichtet, sondern durch einen speziellen Drucker. Dieser besprüht die Oberfläche des Formteils mit der Beschichtungslösung. Die vorgenannten Verfahren gehören zu den chemischen Lösungsabscheideverfahren, bei denen eine Oberfläche zunächst mit einer Lösung benetzt und anschließend diese Schicht verfestigt wird. Diese Abscheideverfahren können unter Umgebungsbedingungen durchgeführt werden und benötigen daher abweichend zu den Verfahren der chemischen- oder physikalischen Gasphasenabscheidung kein Vakuum. Sie sind daher schneller und kostengünstiger durchführbar. Außerdem lassen sich mit den chemischen Lösungsabscheideverfahren auch große Oberflächen defektfrei beschichten. Die Verfahren der chemischen Lösungsabscheidung sind daher für die massenhafte und preiswerte Herstellung von strukturierten Beschichtungen auf einem Formteil besonders geeignet.

Im Anschluss an das Beschichten von mindestens einem ersten und einem zweiten Bereich der Oberfläche des Formteils erfolgt das teilweise Entfernen der Beschichtung mittels $CO_2$-Schneestrahlen als subtraktives Abtragverfahrens.

Beim $CO_2$-Schneestrahlen erfolgt das Abtragen der Oberfläche mit einem Strahlmittel, nämlich festem Kohlendioxid. Die Abtragleistung beim CO2-Schneestrahlen lässt sich über zahlreiche Einflussparameter genau justieren, insbesondere den Massenstrom des Strahlmittels, den Strahldruck, den Volumenstrom der Druckluft, die Relativgeschwindigkeit zwischen dem Strahl und der Oberfläche, den Arbeitsabstand, den Strahlauftreffwinkel und die Partikelgeschwindigkeit des Strahlmittels. Das Abtragen der Beschichtung beruht beim $CO_2$-Schneestrahlen auf einem mechanischen Effekt, einem thermischen Effekt und einem Sublimationseffekt. Der mechanische Effekt beruht auf der hohen Auftreffgeschwindigkeit der festen Kohlendioxid-Partikel. Der thermische Effekt beruht auf der schlagartigen Abkühlung der Beschichtung durch den auftreffenden Strahl, wodurch thermische Spannung zwischen der Beschichtung und der Oberfläche des Formteils hervorgerufen werden. Der Sublimationseffekt beruht auf der Volumenvergrößerung des festen Kohlendioxids beim Übergang in den gasförmigen Zustand beim Auftreffen auf die Beschichtung.

Ein besonders vorteilhaftes Verfahren für eine massenhafte, preiswerte Herstellung von räumlichen Schaltungsträgern aus Kunststoff mit metallischen Leiterbahnstrukturen zeichnet sich durch eine Kombination der Merkmale der Ansprüche 1, 7, 8, 9 und 10 aus. Demnach wird ein Formteil aus Kunststoff bereitgestellt, wobei jeder erste Bereich der Oberfläche mit Hilfe eines Lasers derart strukturiert wird, dass sich in den ersten Bereichen Haftfestigkeiten von mehr als 100 N/cm2 ergeben. Die metallische Beschichtung wird mit Hilfe eines Laser- oder Plasmabeschichtungsverfahren derart aufgebracht, dass die aufgebrachte Beschichtung eine Porosität von mindestens 3% aufweist. Insbesondere im Zusammenhang mit der porösen Beschichtung führt das $CO_2$-Schneestrahlen zu sauberen Bruchkanten entlang der Grenzen jedes ersten Bereiches.

Nachfolgend wir die Erfindung anhand der Figuren näher erläutert: Es zeigen

**Figuren 1-2** schematische Darstellungen zur Veranschaulichung der Verfahrensschritte zum Herstellen von strukturierten Beschichtungen auf einem Formteil,

**Figur 3** eine schematische Darstellung zur Veranschaulichung des teilweisen Abtragens der Beschichtung,

**Figur 4** eine schematische Darstellung zur Veranschaulichung eines Laserbeschichtungsverfahrens zum Aufbringen einer Beschichtung auf die Oberfläche eines Formteils sowie

**Figur 5** eine Vorrichtung zur Durchführung des erfindungsgemäßen Verfahrens in Seitenansicht und Aufsicht.

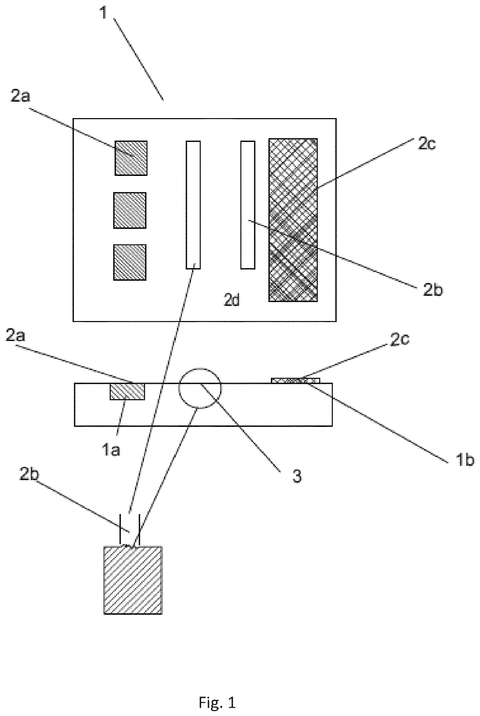

Figur 1 veranschaulicht das Bereitstellen eines quaderförmigen Formteils (1) mit einer Oberfläche, die an Ihrer Oberseite mehrere erste Bereiche (2a, b, c) und einen zweite Bereich (2d) umfasst. Die Oberflächen der ersten Bereichen (2a, b, c) unterscheiden sich von der Oberfläche des zweiten Bereichs (2d) in ihren Oberflächeneigenschaften.

Zur Erzeugung der ersten Bereiche (2a) an der Oberfläche des Formteils (1) sind Blöcke (1a) in das Formteil (1) eingelassen, die aus einem anderen Material als der Rest der Formteils (1) bestehen.

Zur Erzeugung der Oberflächen (2b) wird, wie dies aus der Detailansicht (3) ersichtlich ist, die Oberfläche des Formteils (1) in den zweiten Bereichen (2b) aufgeraut, sodass sich gegenüber der angrenzenden Oberfläche des zweiten Bereiches (2d) eine rauere Oberfläche ergibt.

Die Oberfläche in dem ersten Bereich (2c) wird dadurch erzeugt, dass das Formteil (1) in demersten Bereich (2c) eine Beschichtung (1b) aufweist, deren Material von dem übrigen Material des Formteils (1) abweicht. Die Materialien der eingelassenen Blöcke (1a) und der Beschichtung (1b) zur Ausbildung der ersten Bereiche (2a bzw. 2c) können jedoch übereinstimmen.

Zur Veranschaulichung wurden in Figur 1 unterschiedliche Möglichkeiten aufgezeigt, um in den ersten Bereichen (2 a, b, c) und zweiten Bereichen (2d) unterschiedliche Oberflächeneigenschaften zu erzeugen. Im Rahmen der massenhaften Herstellung von strukturierten Beschichtungen auf einem Formteil (1) wird vorzugsweise jedoch ausschließlich eine der vorgenannten Möglichkeiten genutzt.

Aufgrund der unterschiedlichen Oberflächeneigenschaften ist die Haftfestigkeit einer auf die Oberseite des Formteils (1) aufzubringenden Beschichtung in den ersten Bereichen (2a, b, c) um mindestens 50% höher als in dem zweiten Bereich (2d).

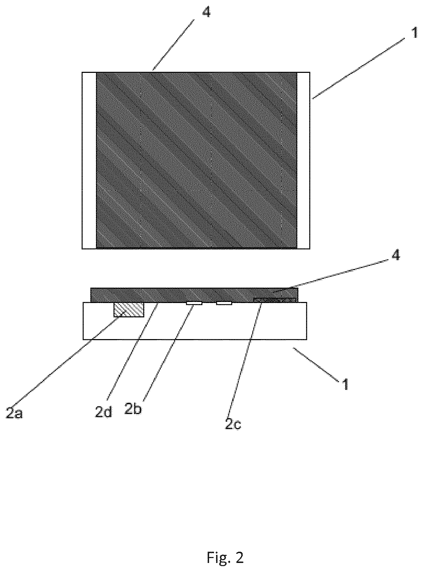

Figur 2 veranschaulicht die auf die Oberseite des Formteils nahezu vollflächig aufgebrachte Beschichtung (4), die wie aus der Seitenansicht erkennbar, sämtliche ersten Bereiche (2a, b, c) und den zweiten Bereich (2d) an der Oberseite des Formteils abdeckt.

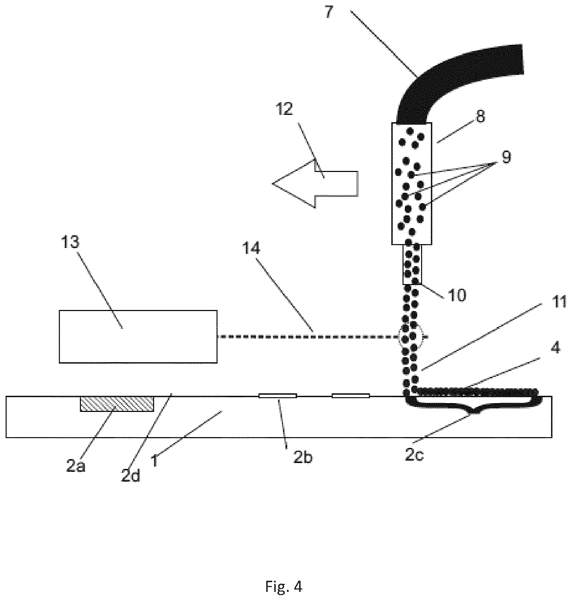

Die Beschichtung (4) wird beispielsweise mit einem Laserbeschichtungsverfahren auf die Oberfläche des Formteils (1) aufgebracht, das nachfolgend anhand der Figur 4 näher erläutert wird.

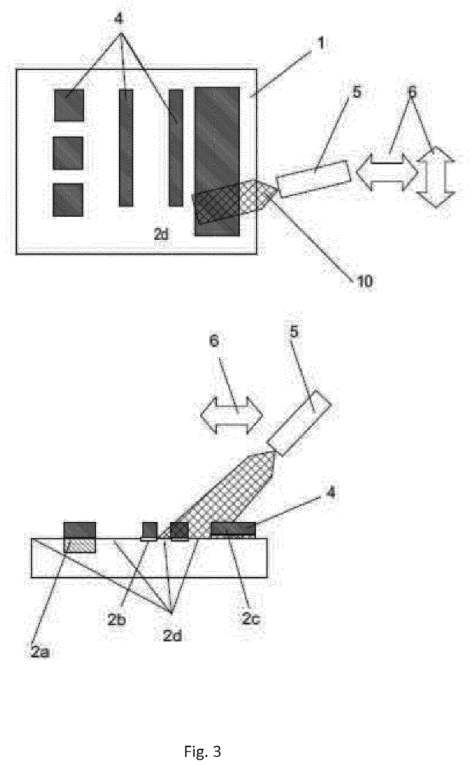

Zum Strukturieren der nahezu vollflächig auf die Oberseite aufgebrachten Beschichtung (4) wird diese, wie dies schematisch in Figur 3 dargestellt ist, wieder teilweise mittels eines Abtragverfahrens von der Oberfläche entfernt. Das teilweise Entfernen der Beschichtung (4) erfolgt mittels $CO_2$-Schneestrahlen. Eine Strahldüse (5) für den Luftstrahl mit festem Kohlendioxid ist relativ zu der beschichteten Oberfläche des Formteils (1) in Richtung der Pfeile (6) beweglich an einer nicht dargestellten Handhabungseinrichtung angeordnet. Die Parameter des $CO_2$-Schneestrahlens werden derart gewählt, dass die Beschichtung (4) in dem zweiten Bereich (2d) vollständig entfernt wird, während sie in sämtlichen ersten Bereichen (2a, b, c) vollflächig erhalten bleibt.

Figur 4 veranschaulicht das Aufbringen der Beschichtung (4) im Wege der Laserbeschichtung. Das Aufbringen des pulverförmigen, metallischen Beschichtungsmaterials umfasst die nachfolgenden Schritte: Über eine Leitung (7) wird ein Gasgemischstrom einer Pulverdüse (8) zugeführt, wobei der Gasgemischstrom (11) Luft als Trägergas und das metallische Beschichtungsmaterial (9) enthält. Der Austritt (10) der Pulverdüse (8) ist auf die zu beschichtende Oberfläche des Formteils (1) gerichtet, sodass der Gasgemischstrom (11) auf die Oberfläche des Formteils (1) auftrifft, wobei die dort durch Relativbewegung in Richtung des Pfeils (12) aufgebrachten Beschichtungsmaterialien die Beschichtung (4) auf der Oberfläche ausbilden. In den Gasgemischstrom (11) wird mittels eines Lasers (13) ein Laserstrahl (14) eingekoppelt, wobei jeder Laserstrahl (14) derart auf den Gasgemischstrom (11) ausgerichtet ist, dass der Laserstrahl (14) die Beschichtung (4) auf der Oberfläche nicht trifft. Der Laserstrahl (14) schmilzt das Beschichtungsmaterial (9) in dem Gasgemischstrom (11) auf, sodass dieses eine haftfeste Verbindung mit den ersten Bereichen (2a, b, c) und dem zweiten Bereich (2d) der Oberfläche des Formteils (1) eingeht, ohne diese unnötig thermisch zu belasten. Infolgedessen lassen sich mit dem Laserbeschichtungsverfahren Formteile (1) aus Kunststoff, insbesondere Polycarbonat beschichten.

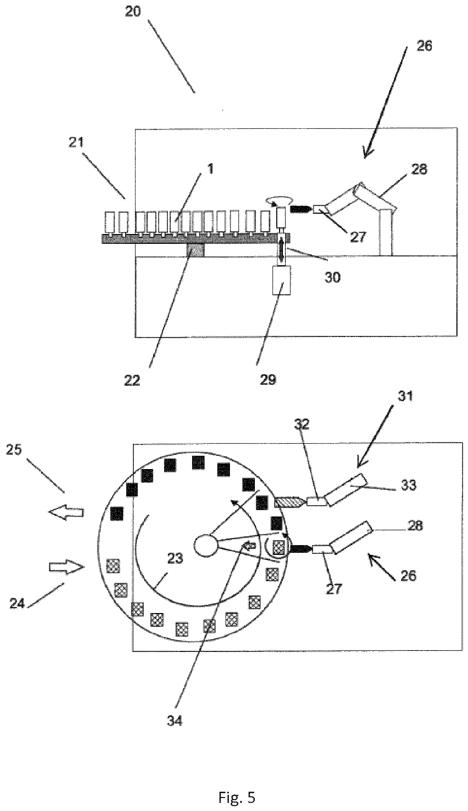

Figur 5 zeigt schematisch eine Vorrichtung die zur Durchführung des vorstehend anhand der Figuren 1-3 beschriebenen Verfahrens eingerichtet ist: Die Vorrichtung (20) umfasst einen als Drehteller ausgebildeten Förderer (21), der um eine Drehachse (22) entgegen dem Uhrzeigersinn in Richtung der in der Aufsicht dargestellten Förderrichtung (23) mithilfe eines motorischen Antriebs drehbar ist. Der Antrieb erlaubt insbesondere ein taktweises Drehen des Drehtellers in Förderrichtung (23).

Die Vorrichtung (20) weist eine Beladestation (24) zum Aufgeben der mit den ersten und zweiten Bereichen versehenen, unbeschichteten Formteile (1) auf den Förderer (21) sowie eine Entladestation (25) zum Entnehmen der mit einer strukturierten Beschichtung versehenen Formteile (1) von dem Förderer (21) auf. In Förderrichtung (23) zwischen der Beladestation (24) und der Entladestation (25) ist eine Beschichtungsstation (26) entlang des Förderwegs der noch unbeschichteten Formteile (1) angeordnet. Die Beschichtungsstation (26) weist als Beschichtungswerkzeug (27) einen Plasmabeschichtungskopf auf, wobei das Beschichtungswerkzeug (27) an einer Handhabungseinrichtung (28) angeordnet ist. Bei der Handhabungseinrichtung (28) kann es sich beispielsweise um einen mehrachsig bewegbaren Industrieroboter handeln, der eine Relativbewegung des Beschichtungswerkezuges (27) zu der zu beschichtenden Oberfläche jedes Formteils (1) erzeugt.

Sofern das im Ausführungsbeispiel quaderförmige Formteil (1) nicht nur an einer Seite, sondern mehrseitig beschichtet werden soll, können am äußeren Umfang des Drehtellers weitere Handhabungseinrichtungen (29) für jedes Formteil (1) angeordnet sein, wobei an jeder Handhabungseinrichtung (29) eine Aufnahme (30) für das Formteil (1) angeordnet ist und die Handhabungseinrichtung (29) zur Erzeugung einer Drehbewegung der Aufnahme (30) um eine Vertikalachse, parallel zu der Drehachse (22) des Drehtellers und einer vertikalen Hubbewegung in Richtung der Drehachse (22) eingerichtet ist. Durch Drehen der Aufnahme (30) lässt sich das Formteil mithilfe der Beschichtungsstation (26) allseitig beschichten. Des Weiteren kann durch die mittels der Handhabungseinrichtung (29) mögliche Hubbewegung die Plasmabeschichtung bahnförmig erzeugt werden, indem die Handhabungsvorrichtung das Formteil (1) in vertikaler Richtung entlang des stillstehenden Plasmabeschichtungskopfes entlang bewegt.

Wie insbesondere aus der Aufsicht in Figur 5 erkennbar, wird gleichzeitig während des Beschichtens eines Formteils (1) auf dem Drehteller ein in Förderrichtung (23) bereits weitergerücktes Formteil (1) einer Abtragstation (31) zugeführt, die zwischen der Beschichtungsstation (26) und der Entladestation (25) angeordnet ist. Die Abtragstation (31) weist ein Abtragwerkzeug (32) in Form einer Stahldüse für festes Kohlendioxid auf. Das Abtragwerkzeug ist an einer Handhabungseinrichtung (33) zur Erzeugung einer Relativbewegung zwischen der teilweise zu entfernenden Beschichtung (4) jedes Formteils (1) und dem Abtragwerkzeug (32) eingerichtet. Auch die Handhabungseinrichtung (32) der Abtragstation (31) kann beispielsweise als mehrachsiger Industrieroboter ausgeführt sein.

Durch die erfindungsgemäße Anordnung der Beschichtungsstation (26) und der Abtragstation (31) entlang des Förderweges der Formteile (1) auf dem Drehteller kann zeitgleich ein Formteil (1) beschichtet werden, ein beschichtetes Formteil abkühlen und von einem abgekühlten, beschichteten Formteil an der Abtragstation (31) die Beschichtung teilweise entfernt werden. Über eine zentrale Absaugung (34), die in die Drehachse (22) des Förderers (21) integriert sein kann, wird überschüssiges Beschichtungsmaterial und überschüssiges Material des $CO_2$-Schneestrahlens zentral abgesaugt und von dem Förderer (21) entfernt.

| Nr. | Bezeichnung |
|---|---|
| 1. | Formteil |
| 1a. | Blöcke |
| 1b. | Beschichtung |
| 2a,b,c. | Erster Bereich |
| 2d. | Zweiter Bereich |
| 3. | Detailansicht |
| 4. | Beschichtung |
| 5. | Strahl-Düse |

(fortgesetzt)

| Nr. | Bezeichnung |
|---|---|
| 6. | Pfeil |
| 7. | Leitung |
| 8. | Pulverdüse |
| 9. | Metall. Beschichtungsmaterial |
| 10. | Austritt |
| 11. | Gasgemischstrom |
| 12. | Pfeil |
| 13. | Laser |
| 14. | Laserstrahl |
| 20. | Vorrichtung |
| 21. | Förderer |
| 22. | Drehachse |
| 23. | Förderrichtung |
| 24. | Beladestation |
| 25. | Entladestation |
| 26. | Beschichtungsstation |
| 27. | Beschichtungswerkzeug |
| 28. | Handhabungseinrichtung |
| 29. | Handhabungseinrichtung |
| 30. | Aufnahme |
| 31. | Abtragstation |
| 32. | Abtragwerkzeug |
| 33. | Handhabungseinrichtung |
| 34a,b. | Absaugungen |

**Patentansprüche**

1. Verfahren zum Herstellen von strukturierten Beschichtungen auf einem Formteil (1) umfassend die Schritte:

   - Bereitstellen eines Formteils (1) mit einer Oberfläche umfassend einen ersten Bereich (2 a, b, c) und einen zweiten Bereich (2 d), wobei sich die Oberfläche in dem ersten Bereich (2 a, b, c) von der Oberfläche in dem zweiten Bereich (2d) in mindestens einer Oberflächeneigenschaft unterscheidet,
   - Aufbringen einer Beschichtung (4) auf die Oberfläche des Formteils (1), die zumindest den ersten Bereich (2 a, b, c) und den zweiten Bereich (2d) abdeckt, wobei die Haftfestigkeit der Beschichtung (4) in dem ersten Bereich (2 a, b, c) aufgrund der mindestens einen unterschiedlichen Oberflächeneigenschaft höher als in dem zweiten Bereich (2 d) ist,
   - teilweise Entfernen der Beschichtung (4),
   - wobei das teilweise Entfernen der Beschichtung (4) mittels des Abtragverfahrens mit einer konstanten Abtragleistung erfolgt, die derart bestimmt wird, dass die Beschichtung (4) in dem zweiten Bereich (2 d) aufgrund der dort geringeren Haftfestigkeit vollständig entfernt wird, während die Beschichtung in dem ersten Bereich (2 a, b, c) vollflächig erhalten bleibt,

   **dadurch gekennzeichnet, dass** das teilweise Entfernen der Beschichtung mittels $CO_2$-Schneestrahlen als Abtragverfahren erfolgt.

2. Verfahren nach Anspruch 1, **dadurch gekennzeichnet, dass** sich die Oberflächen des ersten und zweiten Bereichs (2a, b, c, d) in einer oder mehrerer der nachfolgenden Oberflächeneigenschaften unterscheiden: Rauheit und/oder Härte und/oder Oberflächenspannung und/oder Materialstruktur und/oder Material.

3. Verfahren nach Anspruch 1 oder 2, **dadurch gekennzeichnet, dass** die Oberflächeneigenschaften in dem ersten Bereich (2 a, b, c) und dem zweiten Bereich (2 d) derart bestimmt werden, dass die Haftfestigkeit der Beschichtung in dem ersten Bereich (2 a, b, c) um mindestens 5 % höher als in dem zweiten Bereich (2 d) ist.

4. Verfahren nach einem der Ansprüche 1 oder 2, **dadurch gekennzeichnet, dass** die Oberflächeneigenschaften in dem ersten Bereich (2 a, b, c) und dem zweiten Bereich (2 d) derart bestimmt werden, dass die Haftfestigkeit der Beschichtung in dem ersten Bereich (2 a, b, c) um mindestens 50 % höher als in dem zweiten Bereich (2 d) ist.

5. Verfahren nach einem der Ansprüche 1 bis 4, **dadurch gekennzeichnet, dass** die Haftfestigkeit der Beschichtung (4) mittels des Stirnabzugstests nach DIN EN ISO 4624:2003 ermittelt wird.

6. Verfahren nach einem der Ansprüche 1 bis 5, **dadurch gekennzeichnet, dass** das Aufbringen der Beschichtung auf die Oberfläche des Formteils (1) mit einem Beschichtungsverfahren aus der nachfolgenden Gruppe erfolgt: Laserbeschichtungsverfahren, Plasmabeschichtungsverfahren, Aerosol-Jet-Beschichtungsverfahren, Druck-Beschichtungsverfahren, Tauchbeschichtungsverfahren, chemisches Beschichtungsverfahren.

7. Verfahren nach einem der Ansprüche 1 bis 6, **dadurch gekennzeichnet, dass** Metallpulver im Wege eines Plasmabeschichtungsverfahrens oder eines Laserbeschichtungsverfahrens auf die Oberfläche des Formteils (1) aufgebracht wird.

8. Verfahren nach Anspruch 7, **dadurch gekennzeichnet, dass** das das Metallpulver derart aufgebracht wird, dass die aufgebrachte Beschichtung (4) eine Porosität von mindestens 3% aufweist.

9. Verfahren nach einem der Ansprüche 1 bis 8, **dadurch gekennzeichnet, dass** das bereitgestellte Formteil (1) aus Kunststoff besteht.

10. Verfahren nach einem der Ansprüche 1 bis 9, **dadurch gekennzeichnet, dass** der erste Bereich (2 a, b, c) der Oberfläche des Formteils mit Hilfe eines Lasers derart strukturiert wird, dass sich eine Haftfestigkeit der Beschichtung (4) in jedem ersten Bereich von mehr als 100 N / cm$^2$ bis maximal 500 N/ cm$^2$ ergibt.

11. Vorrichtung eingerichtet zur Durchführung des Verfahrens nach einem der Ansprüche 1 bis 11, **umfassend**

    - einen Förderer (21), eingerichtet zum Fördern mehrerer der Formteile (1),
    - eine Beladestation (24) zum Aufgeben der Formteile (1) auf den Förderer (21),
    - eine Entladestation (25) zum Entnehmen der Formteile (1) von dem Förderer (21),
    - eine Förderrichtung (23) des Förderers (21) von der Beladestation (24) in Richtung der Entladestation (25),
    - eine zwischen der Beladestation (24) und der Entladestation (25) angeordnete Beschichtungsstation (26), die zum Aufbringen der Beschichtung (4) auf die Oberfläche jedes Formteils (1) eingerichtet ist und
    - eine zwischen der Beschichtungsstation (26) und der Entladestation (25) angeordnete Abtragstation (31), die zum teilweisen Entfernen der Beschichtung (4) mittels eines Abtragverfahrens eingerichtet ist, wobei
    - die Abtragstation (31) ein Abtragwerkzeug (32) und eine Handhabungseinrichtung (33) für das Abtragwerkzeug (32) aufweist, wobei

        - das Abtragwerkzeug (32) zum CO$_2$-Schneestrahlen eingerichtet ist und
        - die Handhabungseinrichtung (33) zur Erzeugung einer Relativbewegung zwischen der teilweise zu entfernenden Beschichtung (4) jedes Formteils (1) und dem Abtragwerkzeug (32) eingerichtet ist.

12. Vorrichtung nach Anspruch 11, **dadurch gekennzeichnet, dass** die Beschichtungsstation (27) ein Beschichtungswerkzeug (27) und eine Handhabungseinrichtung (28) für das Beschichtungswerkzeug (27) aufweist, wobei die Handhabungseinrichtung (28) zur Erzeugung einer Relativbewegung zwischen der zu beschichtenden Oberfläche jedes Formteils (1) und dem Beschichtungswerkzeug (27) eingerichtet ist.

13. Vorrichtung nach Anspruch 12, **dadurch gekennzeichnet, dass** das Beschichtungswerkzeug (27) für eine Laserbeschichtung oder Plasmabeschichtung eingerichtet ist.

14. Vorrichtung nach einem der Ansprüche 11 bis 13, **dadurch gekennzeichnet, dass** der Förderer (21) als Drehteller ausgeführt ist.

15. Vorrichtung nach Anspruch 14, **dadurch gekennzeichnet, dass** am äußeren Umfang des Drehtellers mehrere Handhabungseinrichtungen (29) angeordnet sind, an jeder Handhabungseinrichtung eine Aufnahme (30) für ein Formteil (1) befestigt ist und die Handhabungseinrichtung (29) zur Erzeugung einer Relativbewegung der Aufnahme (30) zur der Oberfläche des Drehteller eingerichtet ist.

**Claims**

1. A method for producing patterned coatings on a moulding (1), comprising the steps:

    - providing a moulding (1) having a surface comprising a first region (2a, b, c) and a second region (2d), wherein the surface in the first region (2a, b, c) differs from the surface in the second region (2d) in at least one surface property,
    - applying a coating (4) to the surface of the moulding (1) which covers at least the first region (2a, b, c) and the second region (2d), the adherence of the coating (4) in the first region (2a, b, c) being higher than in the second region (2d) as a result of the difference in the at least one surface property,
    - partially removing the coating (4),
    - wherein the partial removal of the coating (4) is performed by means of the depletion method with a constant depletion rate which is determined in such a manner that the coating (4) in the second region (2d) is removed completely as a result of the lower adherence there whilst the coating in the first region (2a, b, c) is retained over a full area, **characterized in that** the partial removal of the coating is carried out by means of CO$_2$ snow jetting as depletion method.

2. The method according to claim 1, **characterized in that** the surfaces of the first and second region (2a, b, c, d) differ in one or more of the following surface properties: roughness and/or hardness and/or surface tension and/or material structure and/or material.

3. The method according to claim 1 or 2, **characterized in that** the surface properties in the first region (2a, b, c) and the second region (2d) are determined in such a manner that the adherence of the coating in the first region (2a, b, c) is higher by at least 5% than in the second region (2d).

4. The method according to one of claims 1 or 2, **characterized in that** the surface properties in the first region (2a, b, c) and the second region (2d) are determined in such a manner that the adherence of the coating in the first region (2a, b, c) is higher by at least 50% than in the second region (2d).

5. The method according to one of claims 1 to 4, **characterized in that** the adherence of the coating (4) is determined by a frontal pull-off test according to DIN EN ISO 4624:2003.

6. The method according to one of claims 1 to 5, **characterized in that** the application of the coating to the surface of the moulding (1) is accomplished by a coating method from the following group: a laser coating method, a plasma coating method, an aerosol jet coating method, a print coating method, an immersion coating method, and a chemical coating method.

7. The method according to one of claims 1 to 6, **characterized in that** metal powder is applied by a plasma coating method or a laser coating method to the surface of the moulding (1).

8. The method according to claim 7, **characterized in that** the metal powder is applied in such a manner that the applied coating (4) has a porosity of at least 3%.

9. The method according to one of claims 1 to 8, **characterized in that** the prepared moulding (1) consists of plastic.

10. The method according to one of claims 1 to 9, **characterized in that** the first region (2a, b, c) of the surface of the moulding is patterned by a laser in such a manner that an adherence of the coating (4) in each first region is greater than 100 N/cm$^2$ up to a maximum of 500 N/cm$^2$.

11. A device adapted for implementing the method according to one of claims 1 to 11, comprising

    - a conveyor (21) configured to convey a plurality of the mouldings (1),
- a loading station (24) for placing the mouldings (1) onto the conveyor (21),
- an unloading station (25) for removing the mouldings (1) from the conveyor (21),
- a conveying direction (23) of the conveyor (21) from the loading station (24) towards the unloading station (25),
- a coating station (26) disposed between the loading station (24) and the unloading station (25) which is adapted for applying the coating (4) to the surface of each moulding (1), and
- a depletion station (31) disposed between the coating station (26) and the unloading station (25) which is adapted for partial removal of the coating (4) by means of a depletion method, wherein

    - the depletion station (31) includes a depletion tool (32) and a handling device (33) for the depletion tool (32), wherein
    - the depletion tool (32) is adapted for CO$_2$ snow jetting and
    - the handling device (33) is adapted for producing a relative movement between the coating (4) of each moulding (1) which is to be partially removed and the depletion tool (32) .

12. The device according to claim 11, **characterized in that** the coating station (27) includes a coating tool (27) and a handling device (28) for the coating tool (27), the handling device (28) being configured to generate a relative movement between the surface of each moulding (1) to be coated and the coating tool (27) .

13. The device according to claim 12, **characterized in that** the coating tool (27) is adapted for laser coating or plasma coating.

14. The device according to one of claims 11 to 13, **characterized in that** the conveyor (21) is designed as a turntable.

15. The device according to claim 14, **characterized in that** a plurality of handling devices (29) are disposed on the outer circumference of the turntable, a holder (30) for a moulding (1) is fastened to each handing device and the handling device (29) is configured to generate a relative movement of the holder (30) to the surface of the turntable.

**Revendications**

1. Procédé, destiné à fabriquer des revêtements structurés sur une pièce moulée (1), comprenant les étapes consistant à :

- mettre à disposition une pièce moulée (1) présentant une surface comprenant une première zone (2 a, b, c) et une deuxième zone (2 d), la surface dans la première zone (2 a, b, c) se différenciant de la surface dans la deuxième zone (2d) par au moins une propriété superficielle,
- appliquer un revêtement (4) sur la surface de la pièce moulée (1), qui recouvre au moins la première zone (2 a, b, c) et la deuxième zone (2d), en raison d'au moins une propriété superficielle différente, la force adhésive du revêtement (4) dans la première zone (2 a, b, c) étant plus élevée que celle dans la deuxième zone (2 d),
- retirer partiellement le revêtement (4),
- le retrait partiel du revêtement (4) s'effectuant à l'aide du procédé d'enlèvement, avec une puissance d'enlèvement constante qui est déterminée de telle sorte que du fait de la force adhésive qui y est plus faible, le revêtement (4) dans la deuxième zone (2d) soit totalement retiré, alors que le revêtement dans la première zone (2 a, b, c) reste préservé à pleine surface, **caractérisé en ce que** le retrait partiel du revêtement s'effectue par pulvérisation de neige au $CO_2$.

2. Procédé selon la revendication 1, **caractérisé en ce que** les surfaces des première et deuxième zones (2a, b, c, d) se différencient par une ou plusieurs des propriétés superficielles suivantes : rugosité et/ou dureté et/ou tension superficielle et/ou structure de la matière et/ou matière.

3. Procédé selon la revendication 1 ou 2, **caractérisé en ce que** les propriétés superficielles dans la première zone (2 a, b, c) et dans la deuxième zone (2 d) sont déterminées de telle sorte que la force adhésive du revêtement dans la première zone (2 a, b, c) soit supérieure d'au moins 5 % à celle dans la deuxième zone (2 d).

4. Procédé selon l'une quelconque des revendications 1 ou 2, **caractérisé en ce que** les propriétés superficielles dans la première zone (2 a, b, c) et dans la deuxième zone (2 d) sont déterminées de telle sorte que la force adhésive du revêtement dans la première zone (2 a, b, c) soit supérieure d'au moins 50 % à celle dans la deuxième zone (2 d).

5. Procédé selon l'une quelconque des revendications 1 à 4, **caractérisé en ce que** la force adhésive du revêtement (4) est recherchée à l'aide du test d'arrachement selon la norme DIN EN ISO 4624 : 2003.

6. Procédé selon l'une quelconque des revendications 1 à 5, **caractérisé en ce que** l'application du revêtement sur la surface de la pièce moulée (1) s'effectue à l'aide d'un procédé de revêtement compris dans le groupe suivant : procédé de revêtement au laser, procédé de revêtement à plasma, procédé de revêtement au jet aérosol, procédé de revêtement par impression, procédé de revêtement par immersion, procédé de revêtement chimique.

7. Procédé selon l'une quelconque des revendications 1 à 6, **caractérisé en ce qu'**on applique de la poudre métallique sur la surface de la pièce moulée (1) par un procédé de revêtement à plasma ou un procédé de revêtement au laser.

8. Procédé selon la revendication 7, **caractérisé en ce qu'**on applique la poudre métallique de telle sorte que le revêtement (4) appliqué fasse preuve d'une porosité d'au moins 3 %.

9. Procédé selon l'une quelconque des revendications 1 à 8, **caractérisé en ce que** la pièce moulée (1) mise à disposition est en matière plastique.

10. Procédé selon l'une quelconque des revendications 1 à 9, **caractérisé en ce qu'**on structure la première zone (2 a, b, c) de la surface de la pièce moulée à l'aide d'un laser de sorte à obtenir dans chaque première zone une force adhésive du revêtement (4) supérieure à 100 N / $cm^2$ jusqu'à un maximum de 500 N/ $cm^2$.

11. Dispositif, aménagé pour réaliser le procédé selon l'une quelconque des revendications 1 à 11, comprenant

- un convoyeur (21), aménagé pour convoyer plusieurs des pièces moulées (1),
- un poste de chargement (24), destiné à distribuer la pièce moulée (1) sur le convoyeur (21),
- un poste de déchargement (25), destiné à prélever la pièce moulée (1) sur le convoyeur (21)
- une direction de convoyage (23) du convoyeur (21), du poste de chargement (24) dans la direction du poste de déchargement (25),
- un poste de revêtement (26), placé entre le poste de chargement (24) et le poste de déchargement (25) qui est aménagé pour appliquer le revêtement (4) sur la surface de chaque pièce moulée (1) et
- un poste d'enlèvement (31), placé entre le poste de revêtement (26) et le poste de déchargement (25) qui est aménagé pour retirer partiellement le revêtement (4) à l'aide d'un procédé d'enlèvement,
- le poste d'enlèvement (31) comportant un outil d'enlèvement (32) et un système de manipulation (33) pour l'outil d'enlèvement (32),

- l'outil d'enlèvement (32) étant aménagé pour la pulvérisation de neige $CO_2$ et
- le système de manipulation (33) étant aménagé pour créer un déplacement relatif entre le revêtement (4) qu'il s'agit de retirer partiellement de chaque pièce moulée (1) et l'outil d'enlèvement (32).

12. Dispositif selon la revendication 11, **caractérisé en ce que** le poste de revêtement (27) comporte un outil de revêtement (27) et un système de manipulation (28) de l'outil de revêtement (27), le système de manipulation (28) étant aménagé pour créer un déplacement relatif entre la surface qu'il s'agit de revêtir de chaque pièce moulée (1) et l'outil de revêtement (27).

13. Dispositif selon la revendication 12, **caractérisé en ce que** l'outil de revêtement (27) est aménagé pour un revêtement au laser ou un revêtement à plasma.

14. Dispositif selon l'une quelconque des revendications 11 à 13, **caractérisé en ce que** le convoyeur (21) est conçu sous la forme d'un plateau tournant.

15. Dispositif selon la revendication 14, **caractérisé en ce que** sur la périphérie extérieure du plateau tournant sont placés plusieurs systèmes de manipulation (29), sur chaque système de manipulation est fixé un logement (30) pour une pièce moulée (1) et le système de manipulation (29) est aménagé pour créer un déplacement relatif du logement (30) vers la surface du plateau tournant.

Fig. 1

4

1

4

2a    2d  2b    2c

1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 112012004940 T5
- GB 2089581 A
- US 2893150 A